# FASCICULE DE BREVET EUROPEEN

(11) **EP 0 857 010 B1**
(45) Date de publication et mention de la délivrance du brevet: **26.04.2006**
(21) Numéro de dépôt: 97500169.4
(22) Date de dépôt: 09.10.1997
(51) Int. Cl.: H05K 3/20, H05K 3/06

(54) **Procédé de fabrication de circuits imprimés**
Verfahren zur Herstellung von Leiterplatten
Manufacturing process for printed circuits

(30) Priorité: 31.01.1997 ES 9700184
(43) Date de publication de la demande: 05.08.1998
(73) Titulaire: MECANISMOS AUXILIARES INDUSTRIALES S.A. M.A.I.S.A., E-43800 Valls, Tarragona (ES)
(72) Inventeur: Kroebel Nieto, Rodolfo, 43800 Valls, (Tarragona) (ES)
(74) Mandataire: Primo de Rivera y Urquijo, Jose A.

(56) Documents cités:
- DE-A- 1 521 770
- DE-A- 1 665 944
- GB-A- 971 775
- GB-A- 2 263 817
- US-A- 3 138 503
- US-A- 3 177 103
- PATENT ABSTRACTS OF JAPAN vol. 14, no. 380 (E-0965), 16 août 1990 & JP 02 138793 A (SHINKO ELECTRIC IND CO), 28 mai 1990,

## Description

La présente demande de brevet d invention consiste, conformément à son énoncé, en "UN PROCEDE DE FABRICATION DE CIRCUITS IMPRIMES" dont les nouvelles caractéristiques de construction, conformation et conception remplissent la mission pour laquelle elles ont été conçues avec un maximum de sécurité et d efficacité. Plus spécifiquement, l'invention se réfère à un changement de technologie dans le procédé de fabrication des circuits imprimés, de ceux qui sont destinés à être intégrés dans les boîtes dites de services, tel que cela est décrit dans le brevet P9200325 du même titulaire. L'augmentation des prestations et donc des fonctions offertes à l'usager de l'automobile entraîne une amélioration continue au niveau de la qualité, du coût et de la taille de ces boites de services, celles-ci devant augmenter de volume si l'on souhaite persister dans l'idée et la technologie de centraliser en leur intérieur la presque totalité des circuits imprimés en plus des fonctions donc ceux-ci sont chargés. Par conséquent, le problème d'espace est très important car bien que les progrès soient importants, tel que le spécifie le brevet P9501610 du même titulaire, les prestations et fonctions susmentionnées ne cessent pas pour autant d augmenter. Ainsi, des prestations et des fonctions qui étaient réservées au haut de gamme il y a quelques années à peine sont d'aujourd'hui offertes sur des voitures et véhicules utilitaires. Les procédés conventionnels de fabrication de circuits imprimés partent essentiellement d un support diélectrique, formé de résines époxis et de fibres de verre ou similaires, auquel est collée une lame de cuivre dont la surface est recouverte d une substance antiacide, ce support étant ensuite soumis à une attaque chimique, en l'ayant préalablement protégé de façon projetée, afin qu une série de pistes conductrices se forme dans les zones souhaitées et sur lesquelles, avec l'usinage correspondant à base de machines d'insertion, l'on introduira a posteriori dans le circuit imprimé ainsi formé les composants de n'importe quel type pour finalement, dans certains cas, fournir une architecture fondée sur le pliage de ces plaques par des méthodes connues selon le brevet P9200325, et/ou la couture de clavettes, aussi bien courtes que longues.

Le degré de perfectionnement sur ces circuits imprimés provient sans doute, pour certains de leurs aspects techniques, de l'utilisation de feuilles de cuivre toujours plus épaisses afin qu un espace plus réduit puisse supporter des intensités plus grandes ou égales; ainsi, sur une même surface, celle du circuit imprimé, il est possible d intégrer un plus grand nombre d'éléments et donc de fonctions, tout ceci afin que, comme mentionné plus haut, le volume de la boite de services puisse être logé dans un espace réduit. La production des pistes et finalement celle des entrepistes et de l'espace formé entre deux pistes conductrices est fondée sur la technique conventionnelle, c'est-à-dire celle de l'attaque chimique, qui produit des sillons formés de parois verticales qui ne le sont pas vraiment, mais plutôt comme on pourra le constater plus avant, sur les dessins ci-joints, ces parois, celles des entrepistes, forment des plans inclinés, ce qui entraîne, sur la totalité des pistes de la plaque de circuit imprimé, une diminution d'environ 3 ou 4% de la surface conductrice, ce pourcentage tendant à augmenter dans la mesure où de plus de grandes épaisseurs de cuivre sur ces circuits sont produites, ainsi que le spécifie le brevet nº 9501610 du même titulaire. Le brevet US-A-3.177.103 décrit un procédé de fabrication de circuits imprimés à dans lequel on procède sur une face d'une feuille de cuivre à une opération d'attaque chimique sur des parties non protégées pour obtenir des pistes et entrepistes suivie de l'application d'un matériau plastique laminé sur le substrat conducteur en exécutant une pression et en foumissant de la chaleur, ce matériau remplissant les entrepistes, pour ensuite procéder sur une face opposée de la feuille de cuivre à une opération d'attaque chimique pour former les pistes. En outre dans le brevet US-A-3.138.503 on décrit l'obtention d'un circuit imprimé à double face par union de deux circuits simples, par ses faces de matériau diélectrique. La finalité de la présente invention est d'introduire une nouvelle forme de construction de ces circuits imprimés, afin de permettre d absorber les pertes de 3 ou 4% qui se produisent dans la fabrication du circuit imprimé par des méthodes conventionnelles , en même temps qu'elle en facilite la fabrication, en réunissant une série d opération sur un seul ensemble, ce qui permet sans aucun doute que certaines des opérations de fabrication puissent être réalisées dans l'usine du fabricant du circuit imprimé et accroître par la même occasion la vitesse de fabrication: les techniques de formation d'un négatif l'attaque chimique postérieure pour la fabrication de pistes étant supprimées. Ce qui se traduit par conséquent en une augmentation du rendement spécifique du procédé général de fabrication, remplaçant des procédés écologiquement négatifs par d autres ne causant aucun dommage à l'environnement. Le but de l'invention est atteint par le procédé défini dans les revendications. D'autres détails et caractéristiques de la demande actuelle de brevet d invention seront présentés dans la description ci-dessous qui fait référence aux figures jointes à ce mémoire dans lequel sont représentés les détails mentionnés. Ces détails sont donnés à titre d'exemple et font référence à un cas possible de réalisation pratique, cet exemple ne demeurant pas limité aux détails qui sont exposés; ainsi, cette description doit être considérée d'un point de vue illustratif et sans limitation d'aucune sorte. Voici une liste détaillée des divers éléments cités dans la présente sollicitude d'invention: (10) feuille de cuivre, (11) base supérieure de (10), (12) base inférieure de (10), (13) sillons ou entrepistes, (14) substrat diélectrique, (15) piste, (16) substrat diélectrique conventionnel, (17) arête, (18) volume, (19) surface découverte.

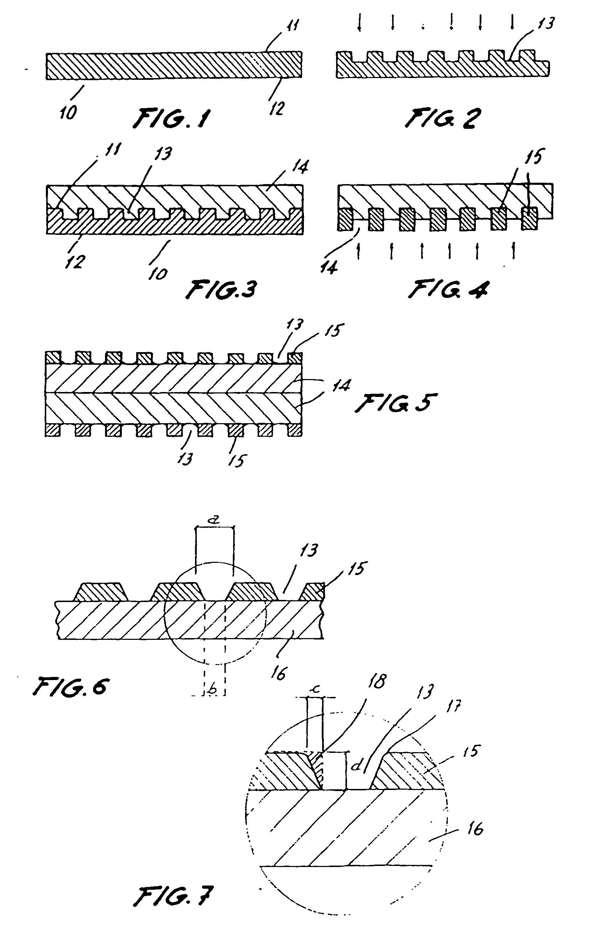

La figure n°1 est une section transversale détaillée d'une feuille de cuivre conventionnelle, du type de celles qui sont utilisées pour la fabrication de circuits imprimés, sur laquelle l'on a distingué la base supérieure ou envers avec le numéro (11), et la base inférieure ou revers de (10) avec le numéro (12).

La figure n° 2 est la plaque (10) représentée sur la figure n° 1 lorsqu un fraisage chimique - également dénommé dans certaines publications coupure chimique - a été effectué sur celle-ci sur les lignes ou points marqués par les flèches, produisant des entrepistes ou des sillons (13) sur la base supérieure (11) du circuit ou feuille (10).

La figure n°3 est une section transversale détaillée permettant d'observer consent, après la production des pistes et des entrepistes (13), selon la figure nº 2, une opération de moulage par injection est effectuée grâce à une substance de type plastique ou similaire, aux caractéristiques diélectriques et résistantes à la température, les entrepistes se remplissant de matériau isolant lors de cette opération, et il reste ainsi une base de support de ce matériau.

La figure n°4 est une section transversale détaillée de la feuille (10) sur laquelle, cette dernière ayant été retournée, l'on applique une attaque chimique, un fraisage ou une coupure chimique des sillons (13) qui doivent coïncider avec ceux de la figure nº 2, les pistes étant ainsi formées (15) de la même façon qu avec le procédé conventionnel de fabrication des circuits imprimés. La figure nº 5 est une exécution où deux réalisations, selon la figure nº 4, ont été unies par température ou à l'aide d'un adhésif.

La figure nº 6 est une représentation de l'état de la technique, de la forme que prennent les sillons (13) lorsque l'on procède à leur formation par des attaques chimiques conventionnelles.

La figure nº 7 est une augmentation de la figure nº6 autour d'un sillon ou entrepiste (13). Comme on peut le voir sur la figure nº 6, une feuille de cuivre est collée sur un support diélectrique (16) par les méthodes conventionnelles de circuits imprimés (10), cette feuille étant recouverte dans les zones où une attaque chimique n'est pas souhaitée, ce qui produit sur la feuille de cuivre les pistes correspondantes (15) et les sillons ou entrepistes (13) dotés de parois du type à plans inclinés, de sorte que la distance entre pistes sur la partie inférieure du sillon, celle qui sépare la feuille de cuivre du substrat diélectrique, possède une largeur inférieure à la partie supérieure.

La conséquence de la production du sillon (13) avec les parois inclinées, selon la figure nº 6, est celle que l'on peut voir sur la figure nº 7, où nous pouvons observer la perte de volume (18) de la piste conductrice (15), le tout résultant de la perte de matériel qui provient de la simple multiplication de la hauteur "d" du matériel conducteur par la largeur "c" et par la longueur de la piste (15).

Les opérations qui composent la fabrication des circuits imprimés préconisés consistent essentiellement, comme on peut le voir de façon séquentielle dans les figures ci-jointes, en la pose d une feuille de cuivre (10) à base supérieure (11) et à base inférieure (12), sur laquelle sont produits des sillons ou entrepistes (13) par le biais de coupure ou fraisage chimique, comme indiqué sur la figure nº 2 qui représente une réalisation purement schématique et illustrative.

Suite à cette coupure ou fraisage chimique vient une opération de moulage par injection d'une substance ou d'un matériau de type plastique entièrement diélectrique et résistant aux températures élevées, car ensuite et tel que cela sera expliqué, il faut pouvoir introduire l'ensemble dans une soudeuse à vague dans laquelle, puisqu il ne s agit pas d'un plastique aux caractéristiques spéciales, il ne pourrait pas supporter la température et des déformations pourraient donc se produire dans le circuit imprimé à fabriquer.

Cette opération de moulage par injection a un double but: en premier lieu doter le circuit imprimé du support diélectrique nécessaire et simultanément protéger efficacement les entrepistes formées, dans lesquelles on pourra observer que les parois des sillons ou entrepistes (13) sont presque entièrement verticales, en même temps que l'on dote l'ensemble (10-14) d'une certaine rigidité mécanique.

Vient ensuite le même procédé pour la partie inférieure, tel que cela est représenté sur la figure nº 4, en procédant à nouveau à une attaque, un fraisage ou une coupure chimique, les pistes (15) se formant alors et permettant que leur section soit parfaitement rectangulaire; ainsi, la perte de matériau ou de volume (18) signalée sur la figure nº 5 ne se produit pas, la conséquence de ceci étant, comme cela a déjà été dit, la formation par les méthodes conventionnelles de plans inclinés au lieu de plans verticaux dans les entrepistes (13).

Avec le circuit ainsi formé par ce nouveau procédé des circuits à double face pourront être formés, voir figure n° 5, par le biais de la disposition d un adhésif aux caractéristiques spéciales pour procéder au collage et former un circuit à double face, il sera également possible d'utiliser la couture de circuits simples, à l'aide de techniques telles que celle de clavettes courtes ou de clavettes longues, comme cela a été introduit dans le brevet P9200365.

L'on envisagera des réalisations équivalentes à celles qui ont été décrites précédemment, celles qui sont constituées de feuilles de matériaux conducteurs similaires à celles du cuivre, ainsi que l'utilisation d'un autre type de substances de nature diélectriques, à la condition que les caractéristiques mentionnées plus haut soient respectées: celles-ci devant permettre de supporter la température et d'être facilement utilisées dans le moule pour former des doubles circuits comme le démontre la figure n° 5.

Outre les avantages mentionnés dans le développement de ce nouveau système de fabrication de circuits, nous pouvons citer celui d'une meilleure isolation des entrepistes (13) par la facilité dans l'opération de moulage par injection pour pourvoir exécuter une pression plus ou moins forte sur le matériau à injecter, ainsi que pour en choisir la nature la plus appropriée, telle que la fluidité, la densité, etc., et accessoirement la protection postérieure des entrepistes (13) est éliminée à l'aide d'un vernis.

## Revendications

1. Procédé de fabrication de circuits imprimés du type de ceux qui sont formés sur la base d'un substrat ou d'une couche diélectrique auquel est collée une lame de cuivre (10), cette dernière étant recouverte de façon sélective d'une pellicule de protection pour obtenir sur sa face extérieure une série de pistes (15) et entrepistes (13) en effectuant une opération d'insertion de composants électriques et/ou électroniques sur lesdites pistes, lequel procédé comprend pour opérations:
- la réalisation sur une face supérieure (11) de la lame de cuivre (10) d'une opération de fraisage chimique de façon programmée et dont le tracé des sillons ou entrepistes (13) est fait en fonction des caractéristiques du circuit ;
- l'application d'un matériau plastique entièrement diélectrique remplissant les entrepistes (13) ; et
- la réalisation sur une face inférieure (12) de la lame de cuivre (10) d'une opération de fraisage chimique, afin de former définitivement les pistes (15);
**caractérisé en ce que** ces opérations de fraisage chimique sont adaptées pour produire des sillons ou entrepistes (13) de section parfaitement rectangulaire, et **en ce que** cette application d'un matériau plastique est réalisée selon un procédé de moulage par injection d'un matériau (14) de type plastique entièrement diélectrique et résistant aux températures élevées, telles que celles qui se produisent dans une soudeuse à vague.

2. Procédé selon la revendication 1, **caractérisé en ce qu'**on procède à l'union des faces libres, dépourvues de pistes, en matériau de type plastique (14),de deux circuits imprimés simples obtenus selon la revendication 1, afin d'obtenir un circuit imprimé à double face.

## Patentansprüche

1. Verfahren zur Herstellung von Leiterbahnen, der Art, die auf Basis eines Substrats oder einer dielektrischer Schichte ausgebildet werden, auf der eine Kupferfolie (10) aufgeklebt wird, wobei letztere selektiv mit einem Schutzfilm beschichtet ist, um auf der Außenseite eine Reihe von Bahnen (15) oder Zwischenbahnen (13) zu erhalten, wobei eine Operation für das Einfügen von elektrischen und/oder elektronischen Komponenten auf diesen Bahnen durchgeführt wird und dieses Verfahren folgende Operationen umfasst:
- auf einer oberen Seite (11) der Kupferfolie (10) wird eine programmierte chemische Fräsoperation durchgeführt, wobei der Verlauf der Rillen oder Zwischenbahnen (13) in Atahängigkeit der Merkmale der Leiterbahn geführt wird;
- es wird ein absolut nichtleitendes Kunststoffmaterial aufgebracht, um die Zwischenbahnen (13) auszufüllen; und
- auf einer unteren Seite (12) der Kupferfolie (10) wird eine chemische Fräsoperation durchgeführt, um die Bahnen (15) endgültig auszubilden;
**dadurch gekennzeichnet, dass** diese chemische Fräsoperationen an die Herstellung von Rillen oder Zwischenbahnen (13) mit einem einwandfrei rechteckigen Querschnitt angepasst werden und **dadurch**, dass das Aufbringen eines Kunsrstoffmaterials nach einem Spritzgießverfahren durchgeführt wird, in dem ein Kunststoffmaterial (14), das absolut nichtleitend und hochhitzebeständig ist, aufgespritzt wird, wie es in einem Wellenlötgerät hergestellt wird.

2. Verfahren nach Anspruch 1, **dadurch gekennzeichnet, dass** die freien Seiten, die nicht mit Bahnen versehen sind, die aus einem Kunststoffmaterial (14) bestehen, welche mit zwei einfachen Leiterbahnen versehen sind, die nach Anspruch 1 erhalten werden, miteinander verbunden werden, um eine doppelseitige Leiterplatte zu erhalten.

## Claims

1. A process for manufacturing printed circuits of the type that are formed on the base of a substrate or a dielectric layer to which a copper strip (10) is adhered, this strip being selectively coated with a protective film so as to obtain on its outer side a series of tracks (15) and intertrack spaces (13), carrying out an operation of inserting electrical and/or electronic components on said tracks, which process comprises the following operations:
- performing a chemical milling operation on a top side (11) of the copper strip (10) in a programmed manner, and in which the layout of the grooves or intertrack spaces (13) is done according to the features of the circuit;
- applying a completely dielectric plastic material, filling in the intertrack spaces (13); and
- performing a chemical milling operation on a bottom side (12) of the copper strip (10) to finally form the tracks (15);
**characterized in that** these chemical milling operations are adapted for the production of grooves or intertrack spaces (13) of a perfectly rectangular section, and **in that** this application of a plastic material is carried out according to a process of injection molding a completely dielectric plastic-type material (14) resistant to high temperatures, such as those produced in a wave solder machine.

2. A process according to claim 1, **characterized in that** the free sides not provided with tracks, of a plastic-type material (14), of two simple printed circuits obtained according to claim 1 are joined together to obtain a double-sided printed circuit.
